# FASCICULE DE BREVET EUROPEEN

(11) **EP 3 051 298 B1**
(45) Date de publication et mention de la délivrance du brevet: **23.09.2020**
(21) Numéro de dépôt: 16153553.9
(22) Date de dépôt: 01.02.2016
(51) Int. Cl.: G01R 15/14, G01R 15/16, G01R 15/18, G01R 19/25

(54) **CAPTEUR DE COURANT ET RÉSEAU ÉLECTRIQUE COMPRENANT UN TEL CAPTEUR DE COURANT**
STROMSENSOR UND EINEN SOLCHEN STROMSENSOR UMFASSENDES STROMNETZ
CURRENT SENSOR AND ELECTRICAL NETWORK COMPRISING SUCH A CURRENT SENSOR

(30) Priorité: 02.02.2015 FR 1550784
(43) Date de publication de la demande: 03.08.2016
(73) Titulaire: Schneider Electric Industries SAS, 92500 Rueil-Malmaison (FR)
(72) Inventeur: Contini, Erick, 38050 Grenoble Cedex 09 (FR); Houbre, Pascal, 38050 Grenoble Cedex 09 (FR); Clemence, Michel, 38050 Grenoble Cedex 09 (FR)
(74) Mandataire: Lavoix

(56) Documents cités:
- EP-A1- 2 136 216
- EP-A1- 2 722 678
- WO-A1-2010/128385
- WO-A1-2012/070035
- WO-A1-2013/026423
- WO-A1-2013/135506
- FR-A1- 2 912 512
- US-A- 5 017 859
- US-A1- 2005 280 423

## Description

La présente invention concerne un capteur de courant, ainsi qu'un réseau électrique comprenant un tel capteur de courant.

Dans le domaine des réseaux électriques de distribution de courant, en particulier des réseaux électriques triphasés, un transformateur MT-BT (moyenne tension-basse tension) est le point de départ de plusieurs ramifications du réseau électrique, notamment des ramifications triphasées. Chaque ramification est généralement équipée d'un ou plusieurs dispositifs de protection, notamment des fusibles et des disjoncteurs. En particulier, trois conducteurs d'une ramification sont équipés chacun d'un fusible au niveau du transformateur et d'un disjoncteur en aval.

Il est souhaitable de surveiller ces dispositifs de protection et, en particulier, il est souhaitable de détecter la fonte d'un des fusibles de la ramification. En effet, les fusibles, disposés en sortie du transformateur, peuvent fondre sous l'effet d'une surintensité importante qui ne serait pas éliminée par un des disjoncteurs installés en aval. De plus, il est important de pouvoir discriminer la cause de la fonte d'un fusible, de préconiser un scénario de reprise et d'éviter une fausse alerte sur le réseau électrique.

Pour ce faire, il est connu de surveiller un courant électrique transmis par le réseau électrique. Une telle approche prévoit l'installation d'un capteur de courant, notamment un tore de Rogowski, sur chaque conducteur de la ramification, afin de mesurer le courant électrique circulant dans ce conducteur. La mesure du courant électrique est ainsi associée à l'utilisation d'un ou plusieurs algorithmes permettant de déduire l'état du fusible. L'analyse de la fonte du fusible par la mesure du courant électrique présente plusieurs risques, notamment une non-détection de la fonte du fusible ou une fausse alerte causée par l'effacement d'une charge ou l'ouverture d'un disjoncteur en aval.

A ce sujet, il est également connu de surveiller les fusibles par la détection dans les conducteurs d'une tension en aval. En particulier, comme décrit par FR-A-2 991 057, il est connu d'équiper un capteur de courant avec des moyens de détection de tension aux bornes du tore de Rogowski. Toutefois, dans les ramifications des réseaux triphasés, chaque capteur est sujet, aux bornes du tore, à une tension parasite induite par les conducteurs voisins. De plus, toujours à cause de l'induction des courants parasites, une tension peut être détectée un aval d'un fusible fondu.

On connaît également les documents EP 2136 216 A1, EP 2 722 678 A1, US 2005/280423 A1, WO 2013/026423 A1, FR 2 912 512 A1, WO 2013/135506, WO 2010/128385 A1 et US 5 017 859 A1.

C'est à ces inconvénients qu'entend plus particulièrement remédier l'invention en proposant un nouveau capteur de courant qui permet de détecter la tension en aval d'un fusible de manière fiable.

Dans cet esprit, l'invention concerne un capteur de courant tel que défini dans la revendication 1.

Grâce à l'invention, le capteur de courant permet, grâce à ses moyens de détection, de réduire sensiblement les risques de non-détection ainsi que de fausse alerte.

Selon des aspects avantageux mais non obligatoires de l'invention, un tel capteur de courant comprend une ou plusieurs des caractéristiques suivantes, prises selon toute combinaison techniquement admissible :
- Les moyens de détection comprennent au moins une électrode capacitive circulaire centré sur un axe central du capteur de courant.
- Une portion de la bande de mesure est directement en vis-à-vis du conducteur électrique, sans interposition du blindage et le blindage entoure radialement la bande de mesure par rapport à l'axe central du capteur de courant.
- Le circuit de comparaison comprend un comparateur analogique configuré pour comparer une tension détectée par la bande de mesure avec un seuil analogique prédéterminé.
- Le circuit de comparaison comprend un convertisseur analogique-numérique configuré pour transmettre une tension détectée par la bande de mesure à un microprocesseur externe équipé d'un seuil numérique prédéterminé.

L'invention concerne également un réseau électrique comportant trois conducteurs électriques, chaque conducteur étant apte à transmettre une phase correspondante d'un courant électrique et équipé d'un capteur de courant. Le réseau électrique comporte également une unité de contrôle distante équipée d'un microprocesseur adapté pour recevoir un résultat d'au moins une comparaison. Conformément à l'invention, le capteur de courant est tel que décrit ci-dessus.

Selon un mode particulier de réalisation, le réseau électrique est tel que le seuil du circuit de comparaison de chaque capteur est déterminé comme la moyenne entre une première valeur de seuil définie en fonction du conducteur électrique qu'il entoure et une deuxième valeur de seuil définie en fonction des deux conducteurs électriques adjacents.

L'invention sera mieux comprise et d'autres avantages de celle-ci apparaîtront plus clairement à la lumière de la description qui va suivre, donnée uniquement à titre d'exemple non limitatif et faite en référence aux dessins annexés, dans lesquels :
- la figure 1 est une représentation schématique d'un réseau électrique conforme à l'invention, chaque conducteur étant équipé d'un capteur de courant conforme à l'invention ;
- la figure 2 est une vue en perspective de trois capteurs de courant conformes à l'invention reliés électriquement à une unité externe;
- la figure 3 est une représentation schématique d'un capteur de courant installé sur un conducteur électrique ;
- la figure 4 est une vue en éclatée et en perspective du capteur de la figure 3 ;
- la figure 5 est une coupe, selon le plan V à la figure 4, d'un boîtier du capteur de courant de la figure 4 ;
- la figure 6 est un schéma équivalent d'un circuit de comparaison du capteur de courant des figures 3 à 5 ;
- la figure 7 est un schéma équivalent d'un couplage étoile dans l'unité externe ;
- la figure 8 est une vue en éclatée et en perspective d'un capteur de courant conforme à un deuxième exemple ;
- la figure 9 est une coupe analogue à la figure 5 pour le capteur de courant de la figure 8 et
- la figure 10 est une figure analogue à la figure 3 pour un capteur de courant conforme à un mode de réalisation de l'invention.

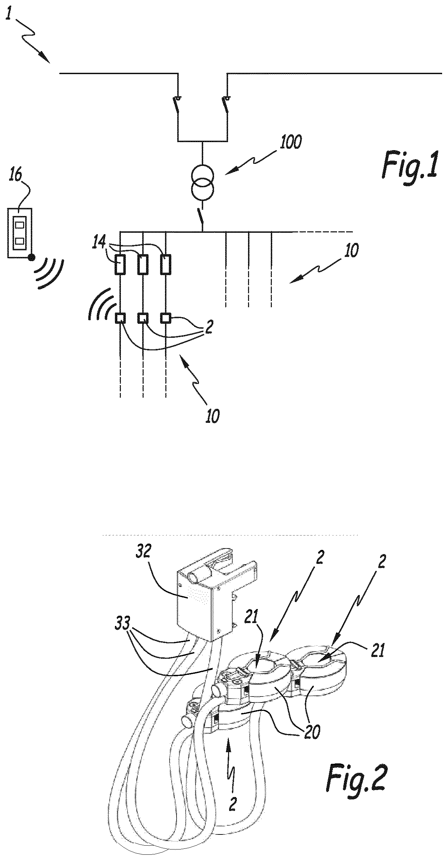

Sur la figure 1, un réseau électrique triphasé 1 est configuré pour transmettre un courant électrique. Le réseau 1 est équipé d'un transformateur 100, tel qu'un transformateur MT-BT (moyenne tension-basse tension). Le transformateur 100 est une source d'alimentation en courant électrique pour des ramifications triphasées 10 positionnées en aval du transformateur 100. Chaque ramification 10 comporte trois conducteurs électriques 12, chacun apte à transmettre une phase correspondante du courant électrique circulant dans le réseau électrique triphasé 1.

Chaque conducteur 12 inclut, immédiatement en aval du transformateur 100, un premier dispositif de protection 14, tel qu'un fusible, lequel à la fonction de protéger le conducteur 12 correspondant d'une surcharge électrique. De façon connue en soi, le fusible 14 est configuré pour fondre et créer une interruption dans le conducteur électrique 12 lorsqu'un courant d'intensité supérieure à une valeur donnée circule dans le conducteur 12 pour un temps prédéterminé. Chaque conducteur 12 de la ramification 10 comporte également un deuxième dispositif de protection, tel qu'un disjoncteur électrique, installé en aval sur le conducteur 12. Pour la clarté des dessins, les disjoncteurs électriques ne sont pas représentés.

Chaque conducteur 12 de la ramification 10 est équipé, en aval du fusible 14, d'un capteur de courant 2. Chaque capteur de courant 2 comprend un boîtier 20 qui est circulaire et ainsi disposé autour du conducteur 12 correspondant. Chaque boîtier 20 définit un orifice circulaire 21 de passage d'un conducteur 12, aligné sur un axe X2 qui est un axe central du capteur de courant 2. En d'autres termes, le boîtier 20 entoure le conducteur électrique 12 lorsque le capteur de courant 2 est installé. Le capteur de courant 2 comprend également un tore de mesure 22, notamment un tore de type Rogowski, agencé dans le boîtier 20. De façon connue en soi, le tore de mesure 22 est configuré pour générer, par induction électromagnétique du conducteur 12 qu'il entoure, une tension électrique entre ses bornes.

Le capteur de courant 2 comprend également des moyens 24 de détection de tension configurés pour détecter une tension dans le conducteur 12 en aval du fusible 14. Les moyens de détection 24 sont en partie agencés dans le boîtier 20 du capteur de courant 2 et sont ainsi configurés pour entourer le conducteur 12 lorsque le capteur 2 est installé. En particulier, les moyens de détection 24 comprennent une bande de mesure circulaire 26, un circuit 28 de comparaison et un blindage circulaire 30. Les éléments 26 et 30 sont centrés sur l'axe X2.

La bande de mesure 26 est en métal et est apte à être disposée à une distance non nulle D du conducteur électrique 12. La distance D peut varier, entre une valeur minimale D1 et une valeur maximale D2, en fonction du diamètre du conducteur 12, qui peut être revêtu d'une gaine isolante non représentée. Compte tenu de la différence de diamètre entre le conducteur 12 et l'orifice 21, la distance D peut ne pas être constante autour du conducteur 12.

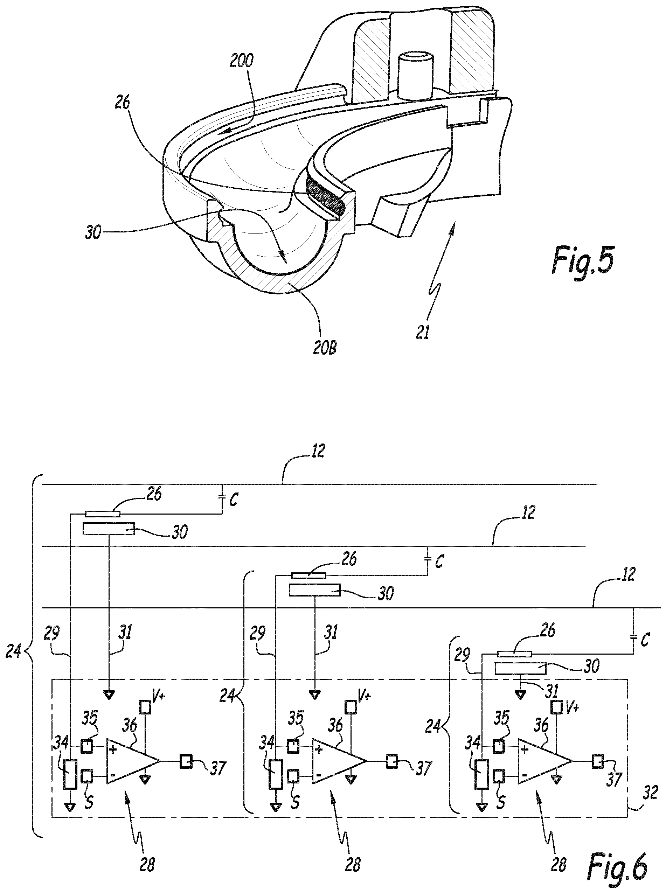

Comme visible sur la figure 5, la bande de mesure 26 est une piste métallique qui est collée sur une surface intérieur 200 du boîtier 20 du capteur de courant 2. Le blindage 30 est formé par une couche de métallisation 30A et 30B apposée sur la surface intérieure 200 du boîtier. En pratique, le boîtier 20 est formé de deux demi-coques 20A et 20B en matériau synthétique qui sont assemblées autour du tore de mesure 22 et le blindage 30 comprend deux parties 30A et 30B respectivement disposées dans les demi-coques 20A et 20B et raccordées électriquement entre elles au niveau d'une ligne de jonction 30C opposée à la bande 26 par rapport au tore de mesure 22. La bande mesure 26 est disposée, radialement par rapport à l'axe X2, à l'intérieur du tore de mesure 22. Ainsi, en configuration installée du capteur de mesure 2 autour du câble 12, la bande 26 est disposée radialement entre les éléments 12 et 22. La bande de mesure 26 est l'élément des moyens 24 qui détecte une tension dans le conducteur 12 en aval du fusible 14. Cette détection est réalisée grâce à une induction électromagnétique du conducteur 12 sur la bande de mesure 26.

Le circuit de comparaison 28 des moyens de détection 24 est apte à comparer la tension détectée par la bande de mesure 26 à une valeur de seuil S prédéterminée. Le circuit de comparaison 28 est situé dans une unité externe 32. Un conducteur 29 est configuré pour relier électriquement la bande de mesure 26 au circuit de comparaison 28 dans l'unité externe 32. Comme représentée à la figure 6, l'unité externe 32 comprend les circuits de comparaison 28 des trois capteurs 2. En parallèle des conducteurs 29, des conducteurs 31 relient les blindages 30 à une masse électrique des circuits de comparaison 28, laquelle constitue un point de zéro volt de l'unité 32.. Les conducteurs 29 et 31 de chaque capteur 2 sont intégrés dans un câble multiconducteurs 33 qui relie ce capteur à l'unité 32 et qui comprend un ou des conducteurs de transmission du signal de sortie du tore de mesure 22.

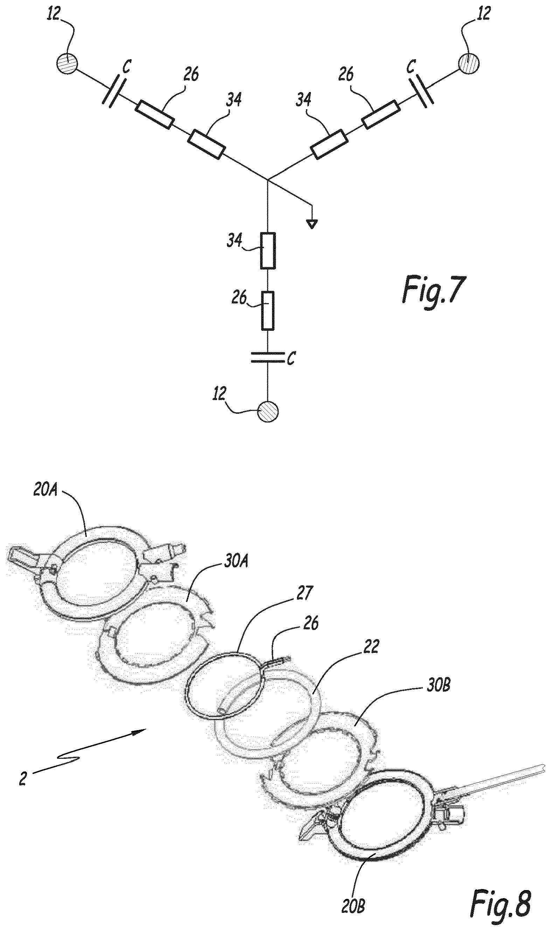

Chaque circuit de comparaison 28 est un comparateur analogique. Le comparateur analogique 28 comprend une résistance de mesure 34, un module 35 de traitement du signal et un amplificateur opérationnel 36. La bande 26, positionnée à la distance D du conducteur 12, détecte par induction un signal de tension, ce qui est représenté par une capacité C sur le schéma électrique de la figure 6. Le signal de tension est transmis au comparateur 28 via le conducteur 29 et est relevé par la résistance de mesure 34. La résistance de mesure 34 est elle-même reliée au point de zéro volt. Cela réalise un couplage étoile des trois résistances de mesure 34 et des trois phases des conducteurs 12, comme représenté à la figure 7. Le point de zéro volt est alors un neutre artificiel du réseau triphasé 1.

Le signal de tension est donc envoyé au module de traitement 35 qui comprend une diode et un intégrateur analogique, non représentés sur la figure. La diode a la fonction de redresseur, c'est-à-dire qu'elle transforme le signal de tension, qui est alternatif, en signal continu, en ne laissant passer qu'une composante positive. L'intégrateur analogique permet d'intégrer le signal afin d'en réduire les variations et de le stabiliser. Le signal de tension est alors fourni en entrée non-inverseuse à l'amplificateur opérationnel 36, qui fonctionne en mode comparateur et qui est alimenté par une tension d'alimentation V+, typiquement 5 volt. Le seuil S est notamment une valeur en tension, typiquement 0,2 volt, et est fourni à l'amplificateur 36 en entrée inverseuse.

De façon connue en soi, le comparateur analogique 28 produit en sortie une valeur de tension dite haute, typiquement 5V volt, dans le cas où la tension détectée est supérieure au seuil S. Au contraire, le comparateur 28 produit en sortie une valeur de tension dite basse, typiquement 0 volt, lorsque la tension détectée est inférieure au seuil S.

Lorsque le fusible 14 surveillé grâce au capteur 2 fond, les moyens 24 détectent une tension sensiblement supérieure au seuil S, ce qui produit en sortie du comparateur 28 la valeur de tension haute. Au contraire, en fonctionnement normal du réseau 1, les moyens 24 détectent une tension inférieure au seuil S, ce qui produit en sortie du comparateur 28 la valeur de tension basse.

La sortie du comparateur 28 est fourni à un micro-processeur 37 de l'unité externe 32. En pratique, en fonction de la sortie haute ou basse du comparateur 28, l'unité externe 32 est apte à générer un signal radio de communication, notamment selon un protocole IEEE 802.11, pour communiquer le résultat de la comparaison à une unité de contrôle distante 16 du réseau électrique 1.

En variante, l'unité externe 32 est équipée en outre d'un composant optoélectronique, tel qu'une diode électroluminescente, et est apte à générer un signal lumineux de communication en direction de l'unité de contrôle 16.La communication entre les unités 32 et 16 peut également avoir lieu par voie filaire.

L'unité de contrôle 16 est ainsi configurée pour créer une alerte dans le cas où une fonte d'un fusible 14 de l'une des ramifications 10 est détectée par un capteur 2. L'unité de contrôle 16 est aussi adaptée pour localiser le conducteur 12 et la ramification 10 où la fonte du fusible a eu lieu.

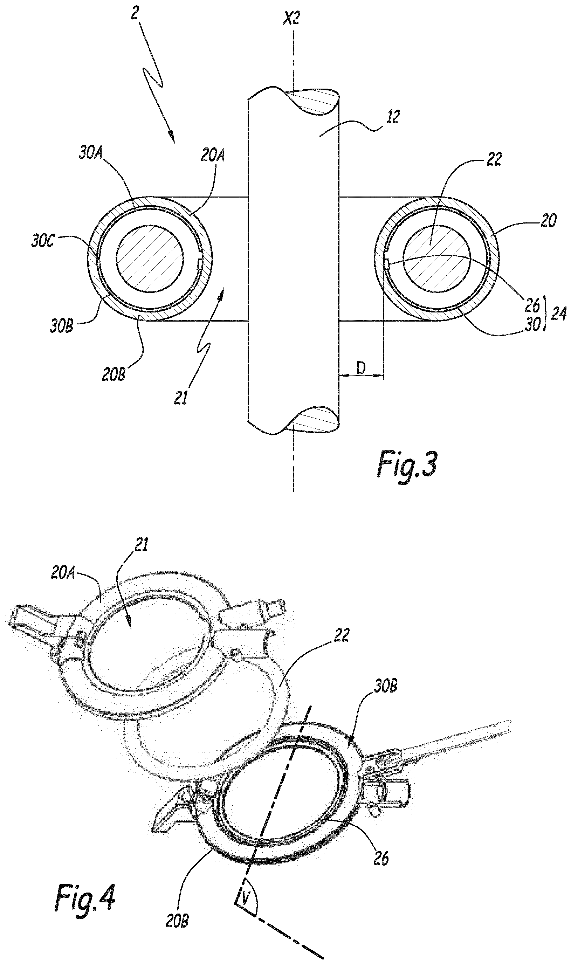

Le blindage 30 des moyens de détection 24 définit la masse électrique des moyens de détection 24. Comme représenté schématiquement à la figure 3, le blindage 30 entoure partiellement la bande de mesure 26. Une portion de la bande de mesure 26 est directement en vis-à-vis du conducteur électrique 12, sans l'interposition du blindage 30. Le blindage 30 entoure ainsi radialement la bande de mesure 26 par rapport à l'axe central X2. La fonction du blindage 30 est ainsi de protéger électriquement les moyens de détection 24 et, plus particulièrement, la bande de mesure 26, des éventuels courants parasites induits par les conducteurs 12 voisins, de manière à ce que la bande de mesure détecte 26 seulement la tension du conducteur 12 qu'elle entoure.

Les figures 8 à 10 montrent un deuxième exemple et un mode de réalisation de l'invention. Les éléments de ces capteurs 2 qui sont identiques à ceux du premier exemple portent les mêmes références et ils ne sont pas décrits en détail dans la mesure où la description ci-dessus peut être transposée à ces éléments.

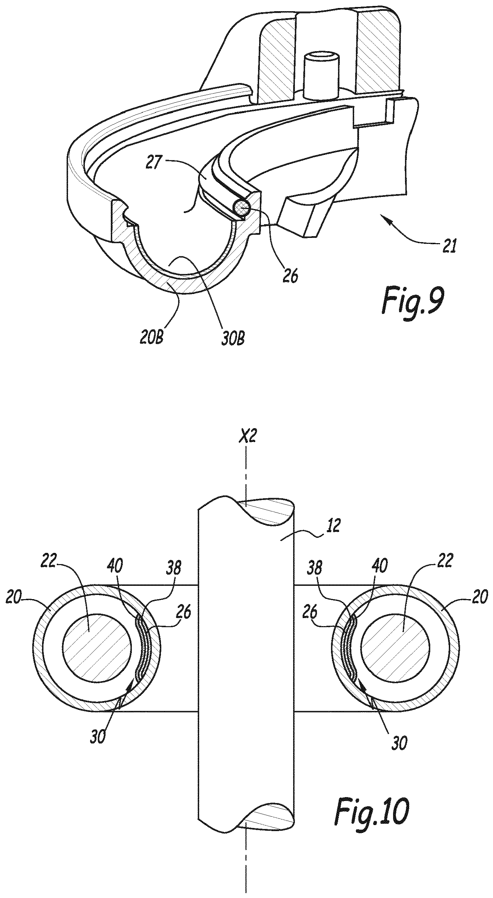

Selon le deuxième exemple, représenté aux figures 8 et 9, la bande de mesure 26 est un conducteur électrique entouré par une gaine isolante 27 elle-même collée à l'intérieur du boîtier 20 et le blindage 30 est une plaque (30A, 30B) surmoulée à l'intérieur du boîtier 20.

Selon le mode de réalisation de l'invention, représenté à la figure 10, la bande de mesure 26 est collée à l'intérieur du boîtier 20 du capteur 2. La bande 26 est ainsi recouverte par une première couche 38 de matériau isolant et une deuxième couche 40 de matériau conducteur, notamment métallique, formant le blindage 30. Dans ce cas, et à l'inverse des deux premiers exemples, le blindage 30 est disposé radialement à l'intérieur du capteur de courant 22.

Selon une variante, qui n'est pas représentée aux figures et peut concerner tous les modes de réalisation mentionnés ci-dessus, le circuit de comparaison 28 comprend un convertisseur analogique-numérique. De façon connue en soi, un convertisseur analogique-numérique reçoit en entrée le signal analogique de tension émis par la bande de mesure 26 et envoie en sortie un signal numérique qui représente ce signal de tension. L'unité externe 32 est alors équipée d'un microprocesseur. Le microprocesseur est pourvu d'un seuil numérique S qui est déterminé par calcul, entre une première valeur de seuil maximale et une deuxième valeur de seuil minimale. En particulier, la première valeur de seuil maximale est définie en fonction des caractéristiques du conducteur électrique 12 que le capteur 2 entoure, ainsi que du courant électrique nominal que le conducteur 12 transmet. La deuxième valeur de seuil minimale est définie en fonction de deux conducteurs électriques 12 adjacents, c'est-à-dire en fonction des courants parasites induits par ces conducteurs adjacents. Le seuil numérique S est déterminé, par exemple, comme la moyenne entre la valeur maximale et la valeur minimale.

Les modes de réalisation et les variantes envisagées ci-dessus peuvent être combinés entre eux pour générer de nouveaux modes de réalisation.

## Revendications

1. Capteur de courant (2) comprenant un tore de mesure (22), agencé dans un boîtier (20) disposé autour d'un conducteur électrique (12) apte à transmettre un courant électrique, et des moyens (24) de détection d'une tension dans le conducteur électrique, les moyens de détection (24) étant configurés pour entourer le conducteur électrique (12) lorsque le capteur de courant (2) est installé, les moyens de détection (24) de tension comprenant une bande de mesure (26) disposée à une distance non nulle (D) du conducteur électrique (12) un blindage (30) qui définit la masse électrique des moyens de détection, et un circuit de comparaison (28) relié électriquement à la bande de mesure, **caractérisé en ce que** la bande de mesure (26) est disposée, radialement par rapport à un axe central (X2) du capteur de courant (2), à l'intérieur du tore de mesure (22), et **en ce que** la bande de mesure (26) est collée à l'intérieur du boîtier (20) du capteur de courant (2) et recouverte par une première couche (38) de matériau isolant et une deuxième couche (40) de matériau conducteur formant le blindage (30).

2. Capteur selon la revendication 1, **caractérisé en ce que** les moyens de détection (24) comprennent au moins une électrode capacitive circulaire (26, 30) centré sur un axe central (X2) du capteur de courant (2).

3. Capteur selon l'une des revendications 1 ou 2, **caractérisé en ce qu'**une portion de la bande de mesure (26) est directement en vis-à-vis du conducteur électrique (12), sans interposition du blindage (30) et **en ce que** le blindage (30) entoure radialement la bande de mesure (26) par rapport à l'axe central (X2) du capteur de courant (2).

4. Capteur selon l'une des revendications 1 à 3, **caractérisé en ce que** le circuit de comparaison (28) comprend un comparateur analogique (34) configuré pour comparer une tension détectée par la bande de mesure (26) avec un seuil (S) analogique prédéterminé.

5. Capteur selon l'une des revendications 1 à 3, **caractérisé en ce que** le circuit de comparaison (28) comprend un convertisseur analogique-numérique configuré pour transmettre une tension détectée par la bande de mesure (26) à un microprocesseur externe équipé d'un seuil (S) numérique prédéterminé.

6. Réseau électrique (1) comportant :
- trois conducteurs électriques (12), chaque conducteur étant apte à transmettre une phase d'un courant électrique et équipé d'un capteur de courant (2),
- une unité de contrôle distante (16),
**caractérisé en ce que** le capteur de courant (2) est selon l'une des revendications précédentes.

7. Réseau électrique selon la revendication 6, **caractérisé en ce que** le capteur est selon la revendication 5 et **en ce que** le seuil (S) du circuit de comparaison (28) de chaque capteur de courant (2) est déterminé par calcul, entre une première valeur de seuil maximale, définie en fonction du conducteur électrique (12) qu'il entoure, et une deuxième valeur de seuil minimale, définie en fonction de deux conducteurs électriques adjacents.

## Patentansprüche

1. Stromsensor (2), umfassend ein Messtoroid (22), das in einem Gehäuse (20) angeordnet ist, das um einen Stromleiter (12) herum angeordnet ist, der zur Übertragung eines elektrischen Stroms geeignet ist, und Mittel (24) zur Erkennung einer Spannung im Stromleiter, wobei die Erkennungsmittel (24) derart eingerichtet sind, dass sie den Stromleiter (12) umgeben, wenn der Stromsensor (2) installiert ist, wobei die Erkennungsmittel (24) einen Messstreifen (26) umfassen, der in einem Abstand ungleich Null (D) zum Stromleiter (12) angeordnet ist,
eine Abschirmung (30), die die elektrische Masse der Erkennungsmittel definiert, und eine Vergleichsschaltung (28), die mit dem Messstreifen elektrisch verbunden ist, **dadurch gekennzeichnet,**
**dass** der Messstreifen (26) radial in Bezug auf eine Mittelachse (X2) des Stromsensors (2) im Inneren des Messtoroids (22) angeordnet ist, und
**dass** der Messstreifen (26) im Inneren des Gehäuses (20) des Stromsensors (2) verklebt und überzogen ist von einer ersten Schicht (38) aus Isoliermaterial und einer zweiten Schicht (40) aus leitfähigem Material, die die Abschirmung (30) bilden.

2. Sensor nach Anspruch 1, **dadurch gekennzeichnet, dass** die Erkennungsmittel (24) mindestens eine kreisförmige kapazitive Elektrode (26, 30), die auf einer Mittelachse (X2) des Stromsensors (2) zentriert ist, umfassen.

3. Sensor nach einem der Ansprüche 1 oder 2, **dadurch gekennzeichnet, dass** ein Abschnitt des Messstreifens (26) dem Stromleiter (12) ohne zwischengeschaltete Abschirmung (30) direkt gegenüberliegt, und dass die Abschirmung (30) den Messstreifen (26) in Bezug auf die Mittelachse (X2) des Stromsensors (2) radial umgibt.

4. Sensor nach einem der Ansprüche 1 bis 3, **dadurch gekennzeichnet, dass** die Vergleichsschaltung (28) einen analogen Vergleicher (34) umfasst, der zum Vergleichen einer vom Messstreifen (26) erkannten Spannung mit einem vorherbestimmten analogen Schwellenwert (S) eingerichtet ist.

5. Sensor nach einem der Ansprüche 1 bis 3, **dadurch gekennzeichnet, dass** die Vergleichsschaltung (28) einen A/D-Wandler umfasst, der zum Übertragen einer vom Messstreifen (26) erkannten Spannung an einen mit einem vorgegebenen analogen Schwellenwert (S) versehenen Mikroprozessor eingerichtet ist.

6. Stromnetz (1), umfassend:
- drei Stromleiter (12), wobei jeder Stromleiter zur Übertragung einer Phase eines elektrischen Stroms geeignet und mit einem Stromsensor (2) versehen ist,
- eine entfernte Steuereinheit (16),
**dadurch gekennzeichnet, dass** es sich beim Stromsensor (2) um einen Stromsensor nach einem der vorstehenden Ansprüche handelt.

7. Stromnetz nach Anspruch 6, **dadurch gekennzeichnet, dass** der Sensor ein Sensor gemäß Anspruch 5 ist und dass der Schwellenwert (S) der Vergleichsschaltung (28) jedes Stromsensors (2) durch Berechnen zwischen einem ersten maximalen Schwellenwert, der als Funktion des von ihm umgebenen Stromleiters (12) definiert wird, und einem zweiten minimalen Schwellenwert, der als Funktion zweier benachbarter Stromleiter definiert wird, bestimmt wird.

## Claims

1. A current sensor (2) comprising a measurement torus (22), arranged in a casing (20) positioned around an electric conductor (12) able to transmit an electric current, and means (24) for detecting a voltage in the electric conductor, the detection means (24) being configured for surrounding the electric conductor (12) when the current sensor (2) is installed, the voltage detection means (24) comprising a measurement strip (26) positioned at a non-zero distance (D) from the electric conductor (12), a shielding (30) which defines the electric ground of the detection means, and a comparison circuit (28) electrically connected to the measurement strip, **characterized in that** the measurement strip (26) is positioned radially with respect to the axis (X2) inside the measurement torus (22), and **in that** the measurement strip (26) is adhesively bonded inside the casing (20) of the sensor (2) and covered with a first layer (38) of insulating material and a second layer (40) of conducting material forming the shielding (30).

2. The sensor according to claim 1, **characterized in that** the detection means (24) comprise at least one circular capacitive electrode (26, 30) centered on a central axis (X2) of the current sensor (2).

3. The sensor according to claim 1 or claim 2, **characterized in that** a portion of the measurement strip (26) is directly facing the electric conductor (12), without interposition of the shielding (30) and **in that** the shielding (30) radially surrounds the measurement strip (26) with respect to the central axis (X2) of the current sensor (2).

4. The sensor according to one of claims 1 a 3, **characterized in that** the comparison circuit (28) comprises an analog comparator (34) configured for comparing a voltage detected by the measurement strip (26) with a predetermined analog threshold (S).

5. The sensor according to one of claims 1 a 3, **characterized in that** the comparison circuit (28) comprises an analog/digital converter configured for transmitting a voltage detected by the measurement strip (26) to an external microprocessor equipped with a predetermined digital threshold (S).

6. An electric network (1) including:
- three electric conductors (12), each conductor being able to transmit one phase of an electric current and equipped with a current sensor (2),
- a remote control unit (16),
**characterized in that** the current sensor (2) is according to one of the preceding claims.

7. The electric network according to claim 6, **characterized in that** the sensor is according to claim 5 and **in that** the threshold (S) of the comparison circuit (28) of each current sensor (2) is determined by calculation, between a first maximum threshold value, defined according to the electric conductor (12) which surrounds it, and a second minimum threshold value, defined according to two adjacent electric conductors.
